(19) **Europäisches Patentamt**
**European Patent Office**
**Office européen des brevets**

(11) **EP 1 278 199 B1**

(12) **FASCICULE DE BREVET EUROPEEN**

(45) Date de publication et mention
de la délivrance du brevet:
**06.10.2010 Bulletin 2010/40**

(51) Int Cl.:
***G11C 16/04*** *(2006.01)*  ***G11C 16/10*** *(2006.01)*
***G11C 16/08*** *(2006.01)*

(21) Numéro de dépôt: **02358013.7**

(22) Date de dépôt: **25.06.2002**

(54) **Mémoire EEPROM protégée contre les effets d'un claquage de transistor d'accès**

**Gegen Zugrifftransistordurchschlag geschützter EEPROM-Speicher**

**EEPROM protected against the effects of access transistor breakdown**

(84) Etats contractants désignés:
**DE FR GB IT**

(30) Priorité: **25.06.2001 FR 0108347**

(43) Date de publication de la demande:
**22.01.2003 Bulletin 2003/04**

(73) Titulaire: **STMicroelectronics SA**
**F-92120 Montrouge (FR)**

(72) Inventeurs:
• **Tailliet, François**
**93800 Epinay sur Seine (FR)**

• **La Rosa, Francesco**
**13790 Rousset (FR)**

(74) Mandataire: **Viering, Jentschura & Partner**
**Postfach 22 14 43**
**80504 München (DE)**

(56) Documents cités:
**EP-A- 0 255 963    GB-A- 2 251 104**
**US-A- 5 414 286    US-A- 5 862 082**
**US-A- 5 981 340    US-A- 5 995 423**

**Description**

La présente invention concerne une mémoire effaçable et programmable électriquement comprenant au moins une ligne de mot comprenant une pluralité de mots, chaque mot comprenant plusieurs cellules mémoire et un transistor de contrôle de grille, chaque cellule mémoire comprenant un transistor à grille flottante et un transistor d'accès, chaque transistor à grille flottante comprenant une grille de contrôle, une première borne reliée au transistor d'accès et une deuxième borne, un décodeur de ligne délivrant au moins un signal de sélection de la ligne de mot, et des premier moyens conducteurs pour amener le signal de sélection sur les grilles des transistors de contrôle de grille de la ligne de mot.

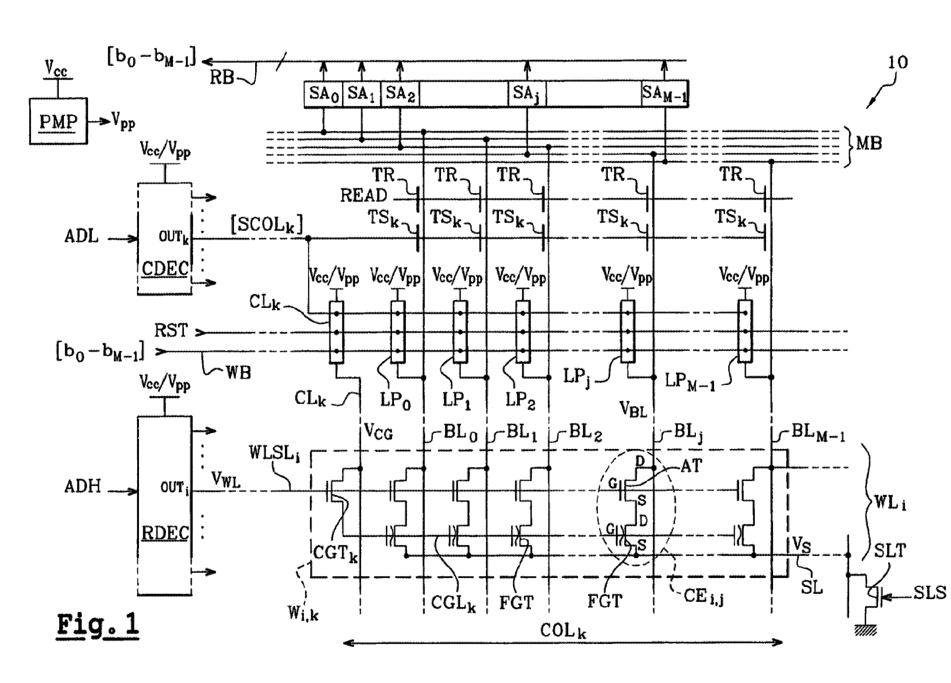

La figure 1 représente un exemple de mémoire EEPROM 10 du type précité. La mémoire comprend des cellules mémoire $CE_{i,j}$ connectées à des lignes de sélection de ligne de mot $WLSL_i$ et à des lignes de bits $Bl_j$. Les lignes de bits sont regroupées en colonnes $COL_k$ comprenant chacune M lignes de bit $BL_0$, ... $BL_j$...,$Bl_{M-1}$. Les cellules mémoire connectées à une même ligne de sélection $WLSL_i$ forment une ligne de mot $WL_i$. Les cellules mémoire d'une même ligne de mot $WL_i$ connectées aux M lignes de bit d'une colonne $COL_k$ forment un mot $W_{i,k}$ permettant de stocker M bits. Dans un souci de simplicité, un seul mot $W_{i,k}$ appartenant à une colonne $COL_k$ et à une ligne de mot $WL_i$ est représenté sur la figure 1.

Chaque cellule mémoire $CE_{i,j}$ comprend un transistor à grille flottante FGT et un transistor d'accès AT de type MOS. Le transistor AT a sa grille G connectée à la ligne $WLSL_i$, son drain D connecté à une ligne de bit $BL_j$ et sa source S connectée au drain D du transistor FGT. Le transistor FGT a sa grille de contrôle G connectée à une ligne de contrôle de grille $CGL_k$ et sa source S connectée à une ligne de source SL. La ligne SL est connectée à la masse par l'intermédiaire d'un transistor SLT piloté par un signal SLS. La ligne $CGL_k$ est reliée à une ligne de sélection de colonne $CL_k$ par l'intermédiaire d'un transistor de contrôle de grille $CGT_k$ ayant sa grille connectée à la ligne $WLSL_i$.

Chaque ligne $WLSL_i$ est contrôlée par un signal $V_{WL}$ délivré par une sortie $OUT_i$ d'un décodeur de ligne RDEC. Chaque ligne $CL_k$ est contrôlée par un signal de contrôle de grille $V_{CG}$ délivré par un verrou de colonne $LT_k$ et chaque verrou $LT_k$ est contrôlé par un signal de sélection de colonne $SCOL_k$ délivré par une sortie $OUT_k$ d'un décodeur de colonne CDEC. Les décodeurs RDEC et CDEC reçoivent respectivement les bits de poids fort ADH et de poids faible ADL de l'adresse d'un mot $W_{i,k}$ à sélectionner.

Chaque ligne de bit $BL_j$ est reliée à un verrou de programmation $LP_j$ piloté par un signal de sélection de colonne $SCOL_k$. Chaque verrou $LP_j$ est connecté à un bus WB pour recevoir, avant une opération de programmation, un bit de données $b_j$ parmi M bits $b_0$ à $b_{M-1}$. Chaque ligne de bit $BL_j$ est également reliée à un amplificateur de lecture $SA_j$ par l'intermédiaire d'un transistor de sélection de colonne $TS_k$, d'un transistor de lecture TR et d'un bus de multiplexage MB. Les transistors $TS_k$ sont pilotés par le signal de sélection de colonne $SCDL_k$ tandis que les transistors TR sont pilotés par un signal de lecture READ. Des amplificateurs de lecture $SA_0$ à $SA_{M-1}$, connectés en entrée au bus MB et en sortie à un bus RB, permettent de lire les M bits d'un mot $W_{i,k}$.

Dans une telle mémoire, les transistors $CGT_k$ permettent de différencier les mots les uns des autres et de les effacer individuellement, tandis que les verrous de programmation permettent de programmer les cellules mémoire individuellement. L'effacement d'un mot ou la programmation d'une cellule mémoire consiste dans l'injection ou l'extraction de charges électriques par effet tunnel (effet Fowler Nordheim) dans la grille flottante des transistors FGT concernés. Un transistor FGT effacé présente une tension de seuil VT1 et un transistor FGT programmé présente une tension de seuil VT2. Lorsqu'une tension de lecture Vread comprise entre VT1 et VT2 est appliquée sur sa grille de contrôle, un transistor FGT effacé reste bloqué, ce qui correspond par convention à un "1" logique, et un transistor programmé est passant, ce qui correspond par convention à un "0" logique.

L'effacement collectif de tous les transistors FGT d'un mot $W_{i,k}$ est obtenu en appliquant une tension Vpp de 15 à 20 V sur la grille de contrôle des transistors FGT, via le transistor de contrôle de grille $CGT_k$ du mot considéré. Simultanément, la ligne de source SL est portée à 0 et le drain des transistors FGT est porté à un potentiel flottant.

La programmation individuelle de transistors FGT est obtenue en appliquant la tension Vpp sur les drains des transistors FGT via les transistors d'accès AT, pendant que la grille de contrôle des transistors FGT est à 0 et que la ligne de source SL est à un potentiel flottant.

Ces opérations sont réalisées au moyen des décodeurs RDEC, CDEC, des verrous $LC_k$ et $LP_j$, en faisant monter la tension d'alimentation Vcc de ces éléments, de l'ordre de 3 à 5V, jusqu'à la tension Vpp.

Le tableau 1 ci-après résume les valeurs des signaux de contrôle pendant les opérations d'effacement, programmation et lecture d'une cellule mémoire $CE_{i,j}$. $V_s$ est le signal de contrôle présent sur la ligne de source SL, $V_{BL}$ est le signal de contrôle présent sur la ligne de bit $BL_j$ et Vsense est un signal délivré par les amplificateurs de lecture.

**Tableau 1**

| Opération ⇒ Signaux de contrôle ⇓ | EFFACEMENT | PROGRAMMATION | LECTURE |
|---|---|---|---|
| $V_{CG}$ | Vpp | 0 (masse) | Vread |
| $V_{WL}$ | Vpp | Vpp | Vcc |
| $V_S$ | 0 (masse) | flottant | 0 (masse) |
| $V_{BL}$ | flottant | Vpp | Vsense |

Une telle mémoire est connue de EP-A-0 255 963.

En raison de l'application de la tension Vpp sur leur grille ou sur leur drain, les transistors d'accès AT et les transistors à grille flottante FGT subissent un stress électrique non négligeable au cours de cycles successifs d'effacement/programmation. Les oxydes de grille de ces transistors sont des oxydes haute tension présumés capables de supporter des tensions pouvant atteindre les 30 V. Toutefois, ces oxydes de grille présentent divers défauts ou impuretés susceptibles d'entraîner leur claquage dans des conditions normales d'utilisation. Bien que la probabilité de claquage d'un transistor soit faible, le nombre de cellules mémoire présent dans une mémoire EEPROM est élevé et, statistiquement, le taux de rejet de mémoires défaillantes n'est pas négligeable.

Pour pallier cet inconvénient, il est connu d'associer aux bits de données stockés dans la mémoire un code de correction d'erreur, ou code ECC, permettant de détecter et corriger au moins un bit erroné dans une chaîne de bits. Par exemple, un code de Hamming de 4 bits ajouté à 8 bits de données permet de détecter et corriger un bit erroné au moment de la lecture de la chaîne de bits. Cette précaution s'avère généralement suffisante pour corriger les conséquences du claquage d'un transistor à grille flottante, mais s'avère inefficace pour pallier une défaillance d'un transistor d'accès.

Ainsi, selon des constatations faites par la demanderesse, il s'avère généralement impossible d'effacer correctement les cellules mémoire d'une ligne de mot $WL_i$ comprenant un transistor d'accès défectueux, ou de programmer correctement des cellules mémoire connectées à une ligne de bit $BL_j$ comprenant un transistor d'accès défectueux.

Comme cela sera expliqué en détail plus loin, ces inconvénients sont attribuables à l'existence d'un court-circuit entre la grille et le drain ou entre la grille et la source du transistor d'accès. Ce court-circuit fait chuter la tension Vpp sur la ligne de sélection de ligne de mot au cours d'un cycle d'effacement, ou fait chuter la tension Vpp sur la ligne de bit au cours d'un cycle de programmation.

La présente invention vise à pallier ces inconvénients.

Plus particulièrement, un objectif de la présente invention est d'éviter que la présence d'une cellule mémoire ayant un transistor d'accès défectueux empêche d'effacer correctement les autres cellules mémoire d'un mot.

Cet objectif est atteint par la prévision d'une mémoire effaçable et programmable électriquement, selon la revendication 1, et un procédé d'effacement et de programmation d'une mémoire effaçable et programmable électriquement selon la revendication 11.

Ces objets, caractéristiques et avantages ainsi que d'autres de la présente invention seront exposés plus en détail dans la description suivante du procédé selon l'invention et d'une mémoire EEPROM selon l'invention, faite à titre non limitatif en relation avec les figures jointes parmi lesquelles :

- la figure 1 précédemment décrite représente un exemple d'architecture de mémoire EEPROM classique,
- la figure 2 est une vue en coupe d'un transistor d'accès dont l'oxyde de grille a claqué,
- les figures 3A à 3E représentent les tensions électriques appliquées à une cellule mémoire EEPROM classique dans cinq situations différentes, et illustrent une analyse de défaillance faisant intégralement partie de la présente invention,
- la figure 4 représente une architecture de ligne de mot selon la présente invention,
- la figure 5 représente une variante de réalisation de l'architecture de ligne de mot représentée en figure 4,
- la figure 6 représente une caractéristique d'un décodeur de ligne selon l'invention, prévue en relation avec l'architecture de ligne de mot représentée sur les figures 4 ou 5,
- la figure 7 représente un variante de réalisation du décodeur de la figure 6,
- la figure 8 est le schéma d'une mémoire EEPROM selon l'invention, et
- la figure 9 est le schéma d'un verrou de programmation selon l'invention.

La présente invention se fonde sur une analyse des problèmes entraînés par la défaillance d'un transistor d'accès d'une cellule mémoire EEPROM, qui va tout d'abord être exposée.

Il sera préalablement noté que l'objectif de la présente invention n'est pas de permettre la réparation d'une cellule mémoire comprenant un transistor d'accès défectueux, dont l'état est irréversible, mais plutôt de maintenir la mémoire dans un état opérationnel malgré l'existence d'un transistor d'accès défectueux. On entend par "état opérationnel" le fait qu'il soit possible de procéder à des opérations d'effacement ou de programmation sur des cellules mémoire voisines appartenant à la même ligne de mot ou à la même ligne de bit que la cellule défectueuse. En d'autres termes, l'idée de la présente invention est de confiner les effets d'une défaillance d'un transistor d'accès à la cellule contenant le transistor d'accès défectueux, et d'éviter une contamination du dysfonctionnement aux cellules voisines, en termes d'effaçabilité ou de programmabilité de ces cellules. En effet, un défaut portant sur une seule cellule mémoire peut être corrigé en lecture par les techniques classiques de correction d'erreur utilisant des codes ECC, par exemple des codes de Hamming, tandis qu'un défaut affectant un ensemble de cellules ne peut être corrigé.

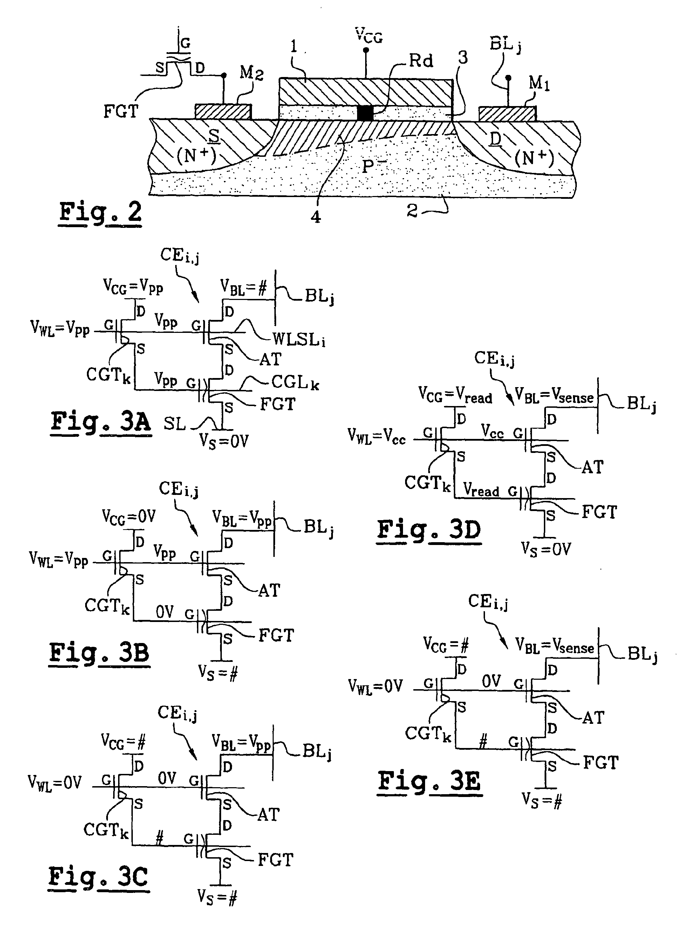

La présente invention repose tout d'abord sur l'hypothèse qu'une défaillance d'un transistor d'accès AT est attribuable à un claquage de l'oxyde de grille. Comme cela est représenté en figure 2, la grille d'un transistor d'accès AT comprend un matériau de grille 1 (silicium polycristallin) déposé sur un substrat de silicium 2, par exemple de type P$^-$, par l'intermédiaire d'une couche d'oxyde 3. Des régions de drain D et de source S, par exemple de type N$^+$, sont implantées de chaque coté du matériau de grille 1. Ces régions de drain et de source sont respectivement connectées, grâce à des contacts métalliques M1 et M2, à une ligne de bit BL$_j$ et au drain D d'un transistor à grille flottante FGT. Un claquage de la couche d'oxyde 3 se traduit par l'apparition d'une résistance de fuite Rd, dont la valeur peut être estimée de l'ordre de quelques centaines de KΩ. Cette résistance Rd est représentée ici dans une position centrale relativement aux régions de drain et de source, mais peut également apparaître en bordure de grille, côté drain ou côté source.

Les figures 3A à 3E représentent une cellule mémoire classique CE$_{i,j}$ dans cinq situations différentes, et illustrent le cheminement suivi par les inventeurs pour comprendre les effets du claquage d'un transistor d'accès sur les cellules mémoire voisines, puis pour trouver des remèdes pratiques, sur la base de l'hypothèse susmentionnée (existence d'une résistance de fuite Rd). Des défauts d'un autre type tel que le claquage d'une ligne conductrice ne sont pas pris en compte ici.

Sur ces figures, l'agencement de la cellule mémoire CE$_{i,j}$ est conforme à celui décrit au préambule et les références des divers éléments sont conservées. La cellule mémoire comprend ainsi un transistor d'accès AT et un transistor FGT. Le transistor AT a sa grille G connectée à une ligne de sélection de ligne de mot WLSL$_i$ recevant un signal de contrôle V$_{WL}$, son drain D connecté à une ligne de bit BL$_j$ recevant un signal de contrôle V$_{BL}$, et sa source connectée au drain du transistor FGT. Le transistor FGT a sa source S connectée à une ligne de source SL recevant un signal de contrôle V$_S$, et sa grille de contrôle connectée à une ligne de contrôle de grille GGL$_k$. La ligne CGL$_k$ reçoit par l'intermédiaire d'un transistor de contrôle de grille CGT$_k$ un signal de contrôle de grille V$_{CG}$ délivré par un verrou de colonne LC$_k$ (non représenté, voir fig. 1). Le transistor CGT$_k$ a par ailleurs sa grille connectée à la ligne de sélection WLSL$_i$.

Sur la figure 3A, la cellule mémoire est en phase d'effacement et les signaux de contrôle présentent les valeurs mentionnées dans le tableau 1 figurant au préambule, colonne "EFFACEMENT". Le transistor d'accès AT reçoit la tension Vpp sur sa grille, son drain est à un potentiel flottant (symbole "#") et sa source est connectée à la masse (V$_s$=0) par l'intermédiaire du transistor FGT, qui est passant (tension Vpp sur la grille de contrôle du transistor FGT). Dans ces conditions, un claquage de la couche d'oxyde entre la grille et la source du transistor d'accès AT provoque un court-circuit entre la tension Vpp et la masse. Il en résulte un effondrement de la tension Vpp car la source de tension délivrant la tension Vpp, par exemple une pompe de charge PMP représentée en figure 1, ne présente pas une sortance suffisante pour supporter le courant de fuite. L'effondrement de la tension Vpp empêche l'effacement des autres cellules mémoire de la ligne de mot concernée.

Un premier objectif de l'invention est ainsi de remédier à ce problème.

Sur la figure 3B, la cellule mémoire est en phase de programmation et les signaux de contrôle présentent les valeurs mentionnées dans le tableau 1, colonne "PROGRAMMATION". Le transistor d'accès AT reçoit la tension Vpp sur sa grille et sur son drain, sa source est à un potentiel flottant (signal V$_s$ flottant et tension nulle sur la grille de contrôle du transistor FGT). Dans ces conditions, un canal conducteur 4 (Cf. fig. 2) apparaît dans le transistor AT. Si l'oxyde de grille du transistor AT est claqué et présente une résistance de fuite Rd, le canal 4 isole la tension Vpp présente sur la grille relativement au substrat de silicium 2. La cellule mémoire est défectueuse et ne pourra pas être lue, mais le défaut n'empêche par la programmation simultanée de cellules mémoire appartenant à la même ligne de mot. Il n'y a donc pas de contamination du défaut aux cellules voisines et le défaut peut être toléré.

Sur la figure 3C, la cellule mémoire n'est pas en phase de programmation mais est connectée à une ligne de bit BL$_j$ recevant la tension Vpp car une autre cellule mémoire connectée à cette ligne de bit est en phase de programmation. Le transistor d'accès AT a sa grille à la masse car la ligne de mot à laquelle il appartient n'est pas sélectionnée. Si l'oxyde de grille du transistor AT est claqué, et que la résistance de claquage Rd se trouve côté drain, la tension Vpp sur la ligne de bit est en court-circuit avec la masse. Il se produit une fuite de courant qui conduit à l'effondrement de la tension Vpp, empêchant la programmation de la cellule mémoire connectée à la ligne de bit.

Un second objectif de la présente invention est ainsi de remédier à ce problème.

Sur la figure 3D, la cellule mémoire est en phase de lecture et les signaux de contrôle présentent les valeurs mentionnées dans le tableau 1, colonne "LECTURE". Le transistor d'accès AT reçoit la tension Vsense sur son drain et la tension Vcc sur sa grille. Sa source est à la masse ($V_s=0$) par l'intermédiaire du transistor FGT (tension Vread sur la grille de contrôle du transistor FGT). Ici, un claquage de la couche d'oxyde de grille du transistor d'accès entraîne un court-circuit entre sa grille et son canal conducteur 4 (fig. 2). L'état du transistor d'accès AT, passant ou bloqué, est incertain. Quoi qu'il en soit, la cellule est considérée comme défectueuse et le bit qui y est lu considéré comme non valable. Le défaut de lecture peut être corrigé au moyen d'un code ECC, comme indiqué plus haut. Il n'y a donc pas de contamination des effets du défaut sur le processus de lecture des cellules voisines et le défaut peut être toléré.

Sur la figure 3E, la cellule mémoire n'est pas en phase de lecture mais est connectée à une ligne de bit $BL_j$ recevant la tension Vsense car une autre cellule mémoire connectée à cette ligne de bit est en train d'être lue. Le drain du transistor d'accès AT reçoit ainsi la tension Vsense, tandis que sa grille est à la masse, la ligne de mot n'étant pas sélectionnée. Ici, un claquage de la couche d'oxyde du transistor d'accès entraîne un court-circuit entre la tension Vsense et la masse, et l'apparition d'un courant de fuite qui fausse la détection de l'état passant ou bloqué de la cellule voisine en cours de lecture. En conséquence, toute autre cellule mémoire connectée à la ligne de bit $BL_j$ ne peut pas être lue correctement. Comme dans le cas précédent, ce défaut peut être toléré et corrigé au moyen d'un code ECC, comme indiqué plus haut, car il ne concerne qu'une seule cellule mémoire par ligne de mot.

En définitive, la présence d'un transistor d'accès défectueux entraîne une erreur de stockage d'un bit qui peut être corrigée en lecture au moyen d'un code de correction d'erreur classique, mais entraîne deux conséquences rédhibitoires, la première apparaissant lors de l'effacement de cellules appartenant à la ligne de mot comprenant le transistor d'accès défectueux, la seconde apparaissant lors de la programmation de cellules connectées à la même ligne de bit que le transistor d'accès défectueux.

On décrira maintenant deux aspects de la présente invention permettant de pallier respectivement chacun de ces deux inconvénients.

Correction des effets du claquage d'un transistor d'accès pendant des phases d'effacement

La présente invention repose ici sur la constatation que l'application de la tension Vpp sur la grille d'un transistor d'accès est inutile pendant l'effacement d'un mot, le processus d'effacement nécessitant seulement l'application de la tension Vpp sur la grille de contrôle des transistors à grille flottante et l'application d'un potentiel électrique de valeur déterminée sur la source de ces transistors, généralement la masse. Ainsi, selon un premier aspect de la présente invention, on propose de ne pas appliquer la tension Vpp sur la grille des transistors d'accès pendant les périodes d'effacement. Plus particulièrement, la tension devant être appliquée sur la grille des transistors d'accès doit être telle que la tension Vpp ne s'effondre pas pendant l'effacement du mot, s'il existe un court-circuit entre la grille et la source d'un transistor d'accès.

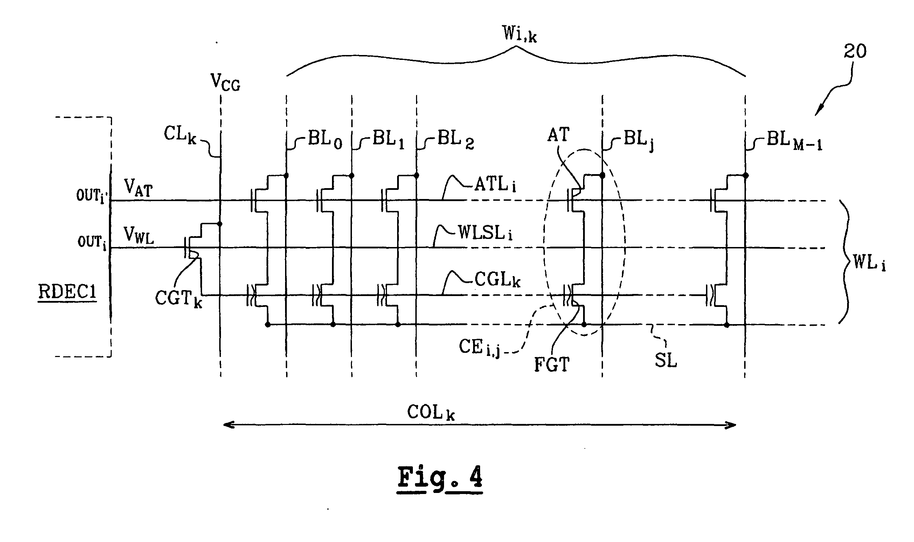

La figure 4 est une vue partielle d'une mémoire 20 selon l'invention et représente une architecture de ligne de mot $WL_i$ permettant de mettre en oeuvre le premier aspect de l'invention. Dans un souci de simplicité de la figure, un seul mot $W_{i,k}$ de M cellules mémoire $CE_{i,j}$ est représenté sur la ligne de mot $WL_i$. Le mot $W_{i,k}$ appartient à une colonne $COL_k$ comprenant M lignes de bit $BL_0$, ... $BL_j$ ... $BL_{M-1}$. De façon classique, chaque cellule mémoire comprend un transistor à grille flottante FGT et un transistor d'accès AT. Le transistor d'accès AT a son drain connecté à une ligne de bit $BL_j$ et sa source connectée au drain du transistor FGT, dont la source est connectée à une ligne de source SL. La grille de contrôle du transistor FGT est connectée à une ligne de contrôle de grille $CGL_k$ qui est reliée à une ligne de sélection de colonne $CL_k$ par l'intermédiaire d'un transistor de contrôle de grille $CGT_k$ commun à toutes les cellules du mot $W_{i,k}$. La ligne de sélection de colonne $CL_k$ reçoit un signal de contrôle de grille $V_{CG}$ délivré par un verrou de colonne (non représenté), et la grille de contrôle du transistor $CGT_k$ est reliée à une ligne de sélection de ligne de mot $WLSL_i$.

Selon l'invention, la grille du transistor d'accès AT de chaque cellule mémoire n'est pas connectée à la ligne de sélection $WLSL_i$. La grille du transistor d'accès AT de chaque cellule mémoire est en effet connectée à une ligne spéciale $ATL_i$, prévue pour piloter les transistors d'accès. La ligne de sélection $WLSL_i$ n'est connectée qu'au transistor de contrôle de grille $CGT_k$, ainsi qu'aux transistors de contrôle de grille des autres mots appartenant à la ligne de mot $WL_i$ (non représentés).

La ligne de sélection $WLSL_i$ est connectée à une sortie $OUT_i$ d'un décodeur de ligne RDEC1 délivrant de façon classique un signal $V_{WL}$ de sélection de ligne de mot. Selon l'invention, le décodeur REDCi comprend une deuxième sortie $OUT_i$', qui est connectée à la ligne $ATL_i$ et qui délivre un signal $V_{AT}$ assurant le contrôle des grilles des transistors d'accès de la ligne de mot.

Le signal $V_{AT}$ est identique au signal $V_{WL}$ pendant des phases de programmation ou de lecture, et la mémoire 20 fonctionne ainsi de façon classique en programmation et lecture. Par contre, pendant des phases d'effacement, le signal $V_{AT}$ est porté à une tension égale à celle du signal $V_S$ se trouvant sur la source des transistors à grille flottante, soit ici une tension nulle.

Le problème exposé plus haut en relation avec la figure 3A n'existe plus ici car les signaux $V_{AT}$ et $V_S$ sont égaux en tension pendant les périodes d'effacement, de sorte que la différence de tension entre la grille d'un transistor d'accès AT et la source du transistor à grille flottante FGT est nulle. Ainsi, le claquage de l'oxyde de grille d'un transistor d'accès ne provoque pas de court-circuit entre la tension Vpp et la tension $V_S$. Le défaut éventuel d'un transistor d'accès est donc confiné à la cellule mémoire contenant le transistor d'accès, sans contamination aux autres cellules, en termes d'effaçabilité de ces cellules, car la tension Vpp ne s'effondre pas.

Le tableau 2 ci-après résume les valeurs des signaux de contrôle pendant les opérations d'effacement, de programmation et de lecture de la mémoire 20. Comme précédemment, le signal de contrôle présent sur la ligne de bit $BL_j$ est désigné $V_{BL}$. La tension Vcc est de l'ordre de 3 à 5V, la tension Vpp de l'ordre de 15 à 20V, la tension délivrée par des amplificateurs de lecture est désignée Vsense. Les valeurs mentionnées en caractère gras distinguent la mémoire selon l'invention d'une mémoire classique. Il apparaît clairement qu'en phase d'effacement la différence de tension entre le signal $V_{AT}$ et le signal $V_S$ est nulle. Il apparaît également qu'en phase de programmation, la structure de ligne de mot selon l'invention permet d'appliquer indifféremment la tension Vpp ou la tension Vcc sur la ligne de sélection de ligne de mot $WLSL_i$ (signal $V_{WL}$), car le transistor de contrôle de grille $CGT_k$ doit seulement connecter à la masse la grille de contrôle des transistors FGT (signal $V_{CG}$ = 0). L'avantage de piloter les transistors de contrôle de grille CGT avec la tension Vcc en phase de programmation, est de limiter le stress électrique subi par ces transistors.

**Tableau 2**

| Opération ⇒<br>Signaux de contrôle ⇓ | EFFACEMENT | PROGRAMMATION | LECTURE |
|---|---|---|---|
| $V_{CG}$ | Vpp | 0 (masse) | Vread |
| $V_{WL}$ | Vpp | Vpp (ou Vcc) | Vcc |
| $V_{AT}$ | 0 (masse) | Vpp | Vcc |
| $V_S$ | 0 (masse) | flottant | 0 (masse) |
| $V_{BL}$ | flottant | Vpp | Vsense |

Ainsi, par rapport à une mémoire classique telle que décrite au préambule, la mise en oeuvre de cet aspect de la l'invention nécessite l'ajout de la ligne $ATL_i$, la modification des connections électriques au niveau des grilles des transistors d'accès AT, et la prévision d'un décodeur de ligne approprié.

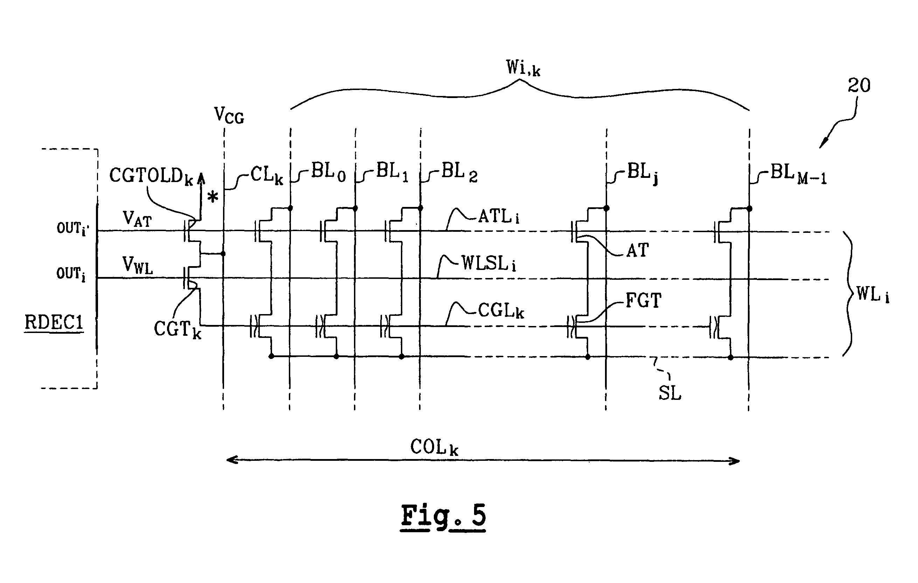

La figure 5 représente une architecture de ligne de mot $WL_i$ semblable à la précédente mais pouvant être obtenue simplement à partir de la topographie ("layout") d'une mémoire classique, avec un minimum de modifications. Le transistor de contrôle de grille originel, désigné $CGTOLD_k$, est conservé mais n'est pas connecté à la ligne de sélection de colonne $CL_k$. Un nouveau transistor de contrôle de grille $CGT_k$ est ajouté à chaque mot présent dans la ligne de mot $WL_i$. Est également ajoutée la ligne de sélection $WLSL_i$, qui correspond en pratique à une ligne métallique passant sur la grille du transistor de contrôle de grille $CGT_k$ (et sur les grilles de contrôle des transistors $CGT_k$ des autres mots présents sur la ligne de mot, non représentés ici). Le drain du transistor inutilisé $CGTOLD_k$ peut être connecté au drain des autres transistors $CGTOLD_k$ présents sur les autres lignes de mot de la mémoire (non représentés).

Ainsi, ce mode de réalisation ne nécessite pas de défaire les connexions originelles entre les grilles des transistors d'accès AT, car la ligne de sélection $WLSL_i$ originelle devient la ligne de contrôle $ATL_i$ réservée aux transistors d'accès AT.

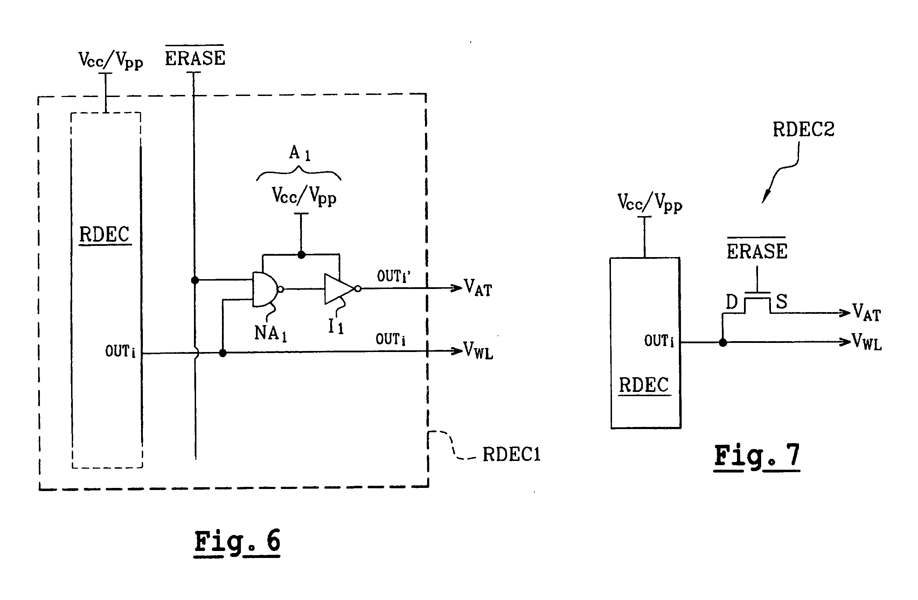

Les modifications à prévoir dans un décodeur de ligne classique RDEC, pour obtenir le décodeur REDC1 selon l'invention, sont également simples comme cela est illustré en figure 6. Sur cette figure, on voit que le décodeur originel REDC est conservé, la sortie $OUT_i$ du décodeur RDEC formant la sortie $OUT_i$ du décodeur RDEC1 selon l'invention. La sortie $OUT_i'$, qui délivre le signal $V_{AT}$, est formée par la sortie d'une porte A1 de type ET recevant en entrée le signal $V_{WL}$ et un signal /ERASE. La porte A1 est obtenue classiquement par l'association d'une porte inverseuse I1 et d'une porte NA1 de type NON ET. Le signal /ERASE est à 1 (tension Vpp) pendant les phases de programmation, et est également à 1 (tension Vcc) pendant les phases de lecture, de sorte que le signal $V_{AT}$ recopie le signal $V_{WL}$. Pendant des phases d'effacement, le signal /ERASE est mis à 0 de sorte que le signal $V_{AT}$ passe à 0.

La valeur en tension du signal $V_{AT}$ assurant une différence de tension nulle entre la grille d'un transistor AT et la source d'un transistor FGT peut également, au lieu d'être la masse, être un potentiel flottant. En effet, s'il existe un court-circuit entre la grille et la source du transistor d'accès, la grille du transistor d'accès se retrouve au même potentiel électrique que la source du transistor à grille flottante ($V_S$), ce qui est compatible avec l'application d'un potentiel flottant sur la ligne $ATL_i$. La figure 7 représente un décodeur RDEC2 selon l'invention dans lequel le signal $V_{AT}$ est délivré par la source S d'un transistor MOS dont le drain D est connecté à la sortie $OUT_i$ du décodeur RDEC. Le transistor MOS est piloté par le signal /ERASE et son drain délivre le signal de contrôle $V_{AT}$ qui est ici flottant quand le signal /ERASE est à 0.

Il va de soi que le signal $V_{AT}$ peut être porté à une autre valeur si la tension $V_S$ appliquée sur la source des transistors à grille flottante est différente de 0. Par exemple, certains procédés d'effacement font intervenir une tension de source négative. On applique dans ce cas une tension négative sur la grille des transistors d'accès pendant les phases d'effacement.

Enfin, une variante du décodeur décrit ci-dessus consiste à prévoir, pendant les phases de programmation, l'application de la tension Vcc au lieu de la tension Vpp sur les grilles des transistors $CGT_k$ afin de limiter le stress électrique de ces transistors, comme cela a déjà été proposé plus haut.

Correction des effets du claquage d'un transistor d'accès pendant des phases de programmation

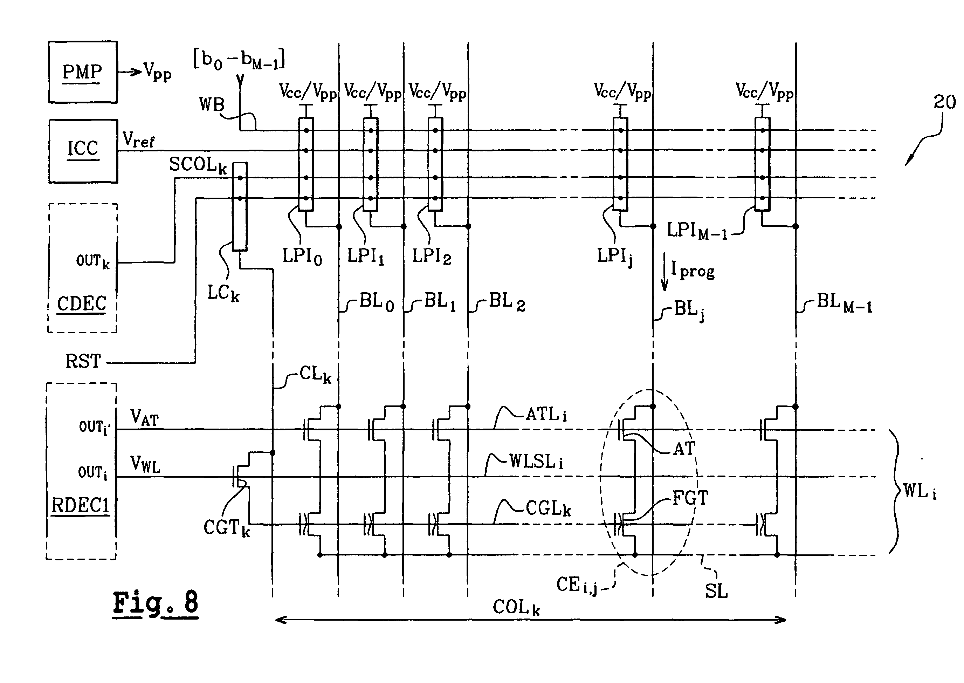

La figure 8 est une vue plus étendue de la mémoire 20. On y retrouve l'architecture de ligne de mot $WL_i$ selon l'invention et le décodeur de ligne REDC1. Sont également représentés un décodeur de colonne CDEC classique, un verrou de colonne classique $LC_k$, qui est connecté à la ligne $CL_k$, et des verrous de programmation $LPI_1$, ... $LPI_j$ ..., $LPI_{M-1}$ selon l'invention. Ces verrous sont connectés aux lignes de bit $BL_0$, ...$BL_j$, ... $BL_{M-1}$ de la colonne $COL_k$ ainsi qu'à un bus de données WB permettant d'appliquer aux verrous des bits à programmer. Ils reçoivent également un signal de remise à zéro RST et un signal de sélection de colonne $SCOL_k$. Les autres éléments de la mémoire ne sont pas représentés et sont par exemple identiques à ceux représentés en la figure 1.

Selon l'invention, chaque verrou de programmation $LPI_j$ est asservi en courant par un circuit de contrôle de courant ICC, et délivre dans la ligne bit $BL_j$ à laquelle il est rattaché, pendant une phase de programmation, un courant ne pouvant pas dépasser une valeur maximale Imax. Cette valeur maximale Imax est calculée de manière que la somme des courants délivrés dans chacune des lignes de bit n'excède pas le courant maximal pouvant être délivré par la source de tension Vpp, ici une pompe de charge PMP.

On supposera ici que la mémoire comprend n colonnes de M lignes de bit chacune, et que n*M cellules mémoire sont programmées simultanément (programmation d'une suite de "0" dans toute une page de la mémoire). Si la mémoire est saine, chaque ligne de bit est traversée par un courant nominal de programmation Iprog et le courant délivré par la pompe de charge est égal à n*M*Iprog. Si par contre une ligne de bit comprend un transistor d'accès claqué, cette ligne de bit est traversée par un courant de fuite If qui est nettement supérieur à Iprog mais qui est limité à la valeur Imax imposée par le verrou de programmation concerné.

Ainsi, si l'on suppose que chaque colonne comprend un transistor d'accès claqué, le courant total IP délivré par la pompe de charge est égal à :

$$(1) \quad IP = n*Imax + n(M-1)Iprog$$

En désignant par IPmax le courant maximal pouvant être délivré par la pompe de charge, il vient que le courant Imax imposé dans chaque ligne de bit doit être inférieur à :

$$(2) \quad Imax < [IPmax - n(M-1)Iprog]/n$$

Dans ces conditions, la tension Vpp délivrée par la pompe de charge ne peut pas s'effondrer pendant une phase de programmation, de sorte que le problème exposé en relation avec la figure 3C est résolu.

On a supposé pour le calcul de l'équation (2) que l'on accepte au maximum un transistor d'accès défectueux par colonne, et cela correspond au cas où l'on prévoit un code EEC permettant de corriger un bit et un seul par chaîne de bit. Toutefois, si l'on prévoit un code ECC permettant de corriger K bits par chaîne de bits, la relation (2) devient :

$$(3) \quad Imax < [IPmax - n(M-K)Iprog]/n*K$$

car K bits erronés peuvent être tolérés dans une chaîne de bits.

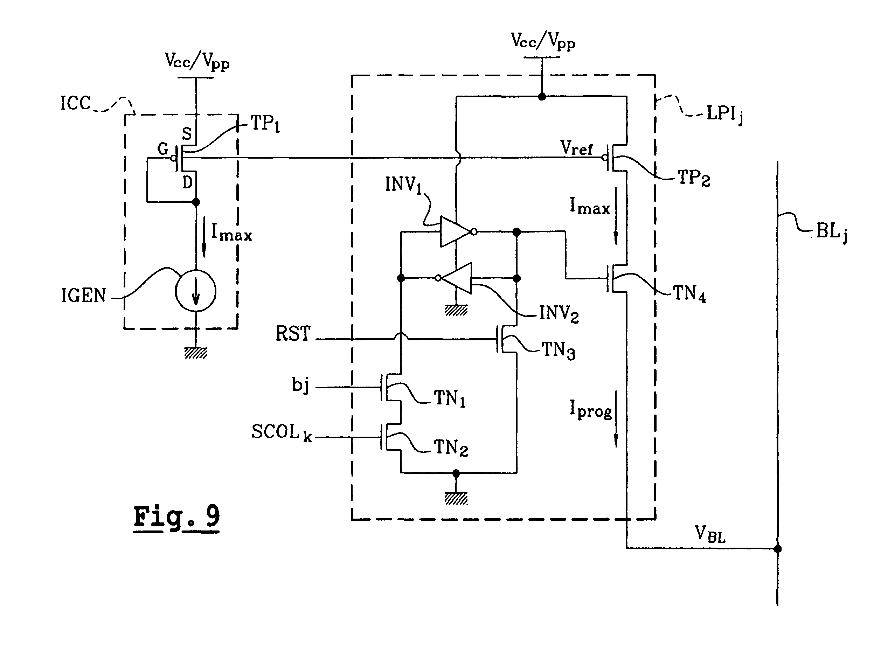

La figure 9 représente un exemple de réalisation du circuit ICC et d'un verrou de programmation $LPI_j$ selon l'invention, dans lequel on utilise le principe du miroir de courant pour contrôler le courant de programmation.

Le circuit ICC comprend un transistor PMOS TP1 ayant sa grille ramenée sur son drain, agencé en série avec un générateur de courant IGEN imposant un courant Imax dans le transistor TP1. Une tension Vref est prélevée sur la grille du transistor TP1 et est appliquée au verrou de programmation $LPI_j$.

Le verrou LPI$_j$ comprend classiquement une cellule mémoire volatile formée par deux portes inverseuses INV1, INV2 connectées tête-bêche. L'entrée de la porte INV1 est reliée à la masse par l'intermédiaire de deux transistors NMOS TN1, TN2. Le transistor TN1 reçoit sur la grille un bit b$_j$ issu du bus de données WB et le transistor TN2 reçoit le signal de sélection de colonne SCOL$_k$. La sortie de la porte INV1 est reliée à la masse par l'intermédiaire d'un transistor NMOS TN3, piloté par le signal de remise à zéro RST. La sortie de la porte INV1 est connectée à la grille d'un transistor NMOS TN4 formant le transistor de sortie du verrou. Le transistor TN4 a sa source connectée à une ligne de bit BL$_j$ associée au verrou et son drain reçoit la tension Vcc/Vpp, c'est-à-dire la tension Vcc pendant le chargement du bit b$_j$ et la tension Vpp pendant la phase de programmation proprement dite.

Selon l'invention, la tension Vcc/Vpp est appliquée sur le drain du transistor TN4 par l'intermédiaire d'un transistor PMOS TP2, ayant un rapport largeur sur longueur de grille W/L identique à celui du transistor TP1 du circuit ICC, et formant un limiteur de courant. La grille du transistor TP2 reçoit le signal Vref délivré par le circuit de contrôle ICC.

Lorsqu'un bit à 0 est appliqué au transistor TN1 et que le signal de sélection SCOL$_k$ est appliqué au transistor TN2, la sortie de la porte INV1 bascule à 1 et le transistor TN4 devient passant. Lorsque la tension Vcc monte à Vpp, le transistor TN4 délivre la tension Vpp sur la ligne de bit BL$_j$ et un courant de programmation Iprog circule dans la ligne de bit. Si les cellules mémoire reliées à la ligne de bit BL$_j$ sont saines, le courant Iprog est de l'ordre du nanoampère car une programmation par effet tunnel ne consomme qu'un courant très faible contrairement à une programmation par injection de porteurs chauds (mémoires Flash). Si par contre une cellule mémoire connectée à la ligne de bit BL$_j$ présente un transistor d'accès claqué, le courant délivré dans la ligne de bit augmente très fortement mais se trouve limité par le transistor TP2 à la valeur Imax, choisie par exemple de l'ordre du microampère.

On a décrit dans ce qui précède un procédé et une architecture de mémoire EEPROM permettant de neutraliser les effets du claquage de transistors d'accès vis-à-vis de cellules voisines, en phase d'effacement d'une part et en phase de programmation d'autre part. En pratique, la présente invention peut être mise en oeuvre en combinaison avec la prévision d'un code ECC permettant de corriger au moins un bit erroné dans chaque mot W$_{i,k}$ de la mémoire. La mémoire obtenue sera résistante aux défauts provenant indifféremment d'un claquage d'oxyde dans un transistor d'accès ou dans un transistor à grille flottante. Des codes ECC de plus grande longueur peuvent également permettre de corriger en lecture des défauts portant sur deux cellules, voire plus, dans chaque mot W$_{i,k}$.

La présente invention est bien entendu susceptible de diverses variantes à la portée de l'homme de l'art, tant en ce qui concerne le choix de la tension à appliquer sur les grilles des transistors d'accès pendant les périodes d'effacement, le choix des moyens permettant d'appliquer cette tension, et le choix des moyens permettant de limiter le courant de programmation Iprog dans les lignes de bit pendant les périodes de programmation.

La présente invention est également applicable à diverses structures de mémoire EEPROM. En particulier, bien que l'on ait décrit dans ce qui précède une mémoire EEPROM du type programmable par page, comprenant autant de verrous de programmation que de lignes de bit, le procédé selon l'invention est également applicable à une mémoire programmable par mot, ne comprenant que M verrous de programmation. Dans ce cas et comme précédemment, les limiteurs de courant selon l'invention sont agencés dans les M verrous ou dans les lignes reliant chaque verrou à la sortie de la source de tension Vpp.

Il apparaîtra clairement à l'homme de l'art que les deux aspects de l'invention décrits ci-dessus sont indépendants et peuvent être mis en oeuvre l'un indépendamment de l'autre, bien que concourrant, en combinaison, à l'obtention d'un résultat commun.

**Revendications**

1. Mémoire effaçable et programmable électriquement, comprenant :

    - au moins une ligne de mot comprenant une pluralité de mots (W$_{i,k}$), chaque mot comprenant plusieurs cellules mémoire (CE$_{i,j}$) et un transistor de contrôle de grille (OGT$_k$), chaque cellule mémoire comprenant un transistor à grille flottante (FGT) et un transistor d'accès (AT), chaque transistor à grille flottante (FGT) comprenant une grille de contrôle, une première borne (D) reliée au transistor d'accès et une deuxième borne (S),

    - un décodeur de ligne (RDEC1) délivrant au moins un signal de sélection (V$_{WL}$) de la ligne de mot, le signal de sélection (V$_{WL}$) présentant une haute tension (Vpp) relativement à une tension (Vcc) d'alimentation de la mémoire au moins pendant des phases d'effacement de cellules mémoire,

    - des premier moyens conducteurs (WLSL$_i$) pour amener le signal de sélection (V$_{WL}$) sur les grilles des transistors de contrôle de grille (CGT$_k$) de la ligne de mot,

    **caractérisée en ce que** qu'elle comprend :

    - des second moyens conducteurs (ATL$_i$), distincts des premiers moyens conducteurs, pour amener le signal de sélection (V$_{WL}$) sur les grilles des transistors d'accès (AT) de la ligne de mot, et
- des moyens (A1, NA1, I1, /ERASE) pour empêcher l'application du signal de sélection (V$_{WL}$) sur les seconds moyens conducteurs pendant l'effacement d'un mot, et appliquer à la place du signal de sélection un signal électrique déterminé (V$_{AT}$) présentant une différence de potentiel faible ou nulle relativement à la deuxième borne des transistors à grille flottante du mot à effacer.

2. Mémoire selon la revendication 1, dans laquelle la deuxième borne des transistors à grille flottante d'un mot à effacer reçoit une tension nulle (V$_S$) pendant l'effacement du mot

3. Mémoire selon l'une des revendications 1 et 2, dans laquelle le signal électrique déterminé (V$_{AT}$) a une valeur en tension nulle pendant l'effacement du mot.

4. Mémoire selon l'une des revendications 1 et 2, dans laquelle le signal électrique déterminé (V$_{AT}$) est porté à un potentiel flottant pendant l'effacement du mot.

5. Mémoire selon l'une des revendications 1 à 4, dans laquelle les moyens pour empêcher l'application du signal de sélection comprennent un circuit logique (A1, NA1, I1) connecté en sortie aux seconds moyens conducteurs (ARL$_i$), recevant en entrée le signal de sélection (V$_{WL}$) et un signal de contrôle (/ERASE), recopiant le signal de sélection lorsque le signal de contrôle présente une première valeur et délivrant le signal électrique déterminé (V$_{AT}$=0) lorsque le signal de contrôle présente une seconde valeur.

6. Mémoire selon l'une des revendications 1 à 5, comprenant :

- des lignes de bit (BL$_j$) connectées aux transistors d'accès (AT), pour la programmation ou la lecture des cellules mémoire,
- des moyens (ICC, LPI$_j$, TP2) pour limiter un courant de programmation (Iprog) circulant dans au moins une ligne de bit pendant la programmation d'au moins une cellule mémoire, quand le courant de programmation atteint une valeur déterminée (Imax), de manière à empêcher le courant de programmation de dépasser la valeur déterminée (Imax).

7. Mémoire selon la revendication 6, comprenant un limiteur de courant (TP2) agencé entre chaque ligne de bit et une source de tension (PMP) fournissait la haute tension (Vpp).

8. Mémoire selon la revendication 7, comprenant un limiteur de courant (TP2) agencé dans un verrou de programmation (LPI$_j$) relié à au moins une ligne de bit.

9. Mémoire selon l'une des revendications 7 et 8, dans laquelle le limiteur de courant (TP2) comprend un transistor piloté par une tension de référence (Vref) délivrée par un circuit de contrôle de courant (ICC) commun à tout ou partie des lignes de bit (BL$_j$) de la mémoire.

10. Mémoire selon l'une des revendications 1 à 9, comprenant des moyens pour appliquer, sur la grille du transistor de contrôle de grille (CGT$_k$) d'un mot à programmer, une tension (Vcc) inférieure à la haute tension (Vpp).

11. Procédé d'effacement et de programmation appliqué à une mémoire effaçable et programmable électriquement comprenant :

- au moins une ligne de mot (WL$_i$) comportant une pluralité de mots (W$_{i,k}$), chaque mot comportant une pluralité de cellules mémoire (CE$_{i,j}$) et un transistor de contrôle de grille (CGT$_k$), chaque cellule mémoire comprenant un transistor d'accès (AT) et un transistor à grille flottante (FGT) présentant une grille de contrôle, une première borne (D) reliée au transistor d'accès et une deuxième borne (S), les grilles des transistors à grille flottante (FGT) d'un même mot (W$_{i,k}$) étant contrôlées par le transistor de contrôle de grille (CGT$_k$) du mot, de telle sorte que chaque mot est effaçable individuellement,
- un décodeur de ligne (RDEC, RDEC1) délivrant au moins à signal de sélection de la ligne de mot (V$_{WL}$), le signal de sélection (V$_{WL}$) présentant une haute tension (Vpp) relativement à une tension (Vcc) d'alimentation de la mémoire au moins pendant des phases d'effacement de cellules mémoire de la ligne de mot,
- des premiers moyens conducteurs (WLSL$_i$) pour amener le signal de sélection (V$_{WL}$) sur les grilles des transistors de contrôle de grille (CGT$_k$) de la ligne de mot, et
- des seconds moyens conducteur (ATL$_i$), distincts des premiers moyens conducteurs, pour amener le signal de sélection ($V_{WL}$) sur les grilles des transistors d'accès des cellules mémoire de la ligne de mot,

procédé dans lequel l'effacement d'un mot de la ligne de mot comprend l'application d'une première tension électrique ($V_{CG}$) égale à la haute tension (Vpp) et d'une seconde tension électrique ($V_s$=0) respectivement sur la grille (G) et sur la deuxième borne (S) des transistors à grille flottante (FGT) du mot à effacer, la première tension étant appliquée aux transistors à grille flottante par l'intermédiaire du transistor de contrôle de grille du mot à effacer,

procédé **caractérisé en ce qu'**il comprend les étapes consistant à prévoir, dans la mémoire, des moyens pour, pendant l'effacement d'un mot, empêcher l'application du signal de sélection ($V_{WL}$, Vpp) sur les seconds moyens conducteurs, et appliquer à la place du signal de sélection un signal électrique déterminé ($V_{AT}$) dont la valeur en tension ($V_{AT}$=0) est différente de la première tension électrique (Vpp) et présente une différence de potentiel faible ou nulle relativement a la seconde tension électrique ($V_s$=0), de telle sorte que les transistors d'accès du mot à effacer reçoivent le signal électrique déterminé ($V_{AT}$).

12. Procédé selon la revendication 11, dans lequel la seconde tension ($V_s$) présente une valeur nulle pendant l'effacement du mot.

13. Procédé selon l'une des revendications 11 et 12, dans lequel le signal électrique déterminé ($V_{AT}$) présente une valeur en tension nulle pendant l'effacement du mot.

14. Procédé selon l'une des revendications 11 et 12, dans lequel le signal électrique déterminé ($V_{AT}$) est porté à un potentiel flottant pendant l'effacement du mot.

15. Procédé selon l'une des revendications 11 à 14, dans lequel on empêche l'application du signal de sélection sur les seconds moyens conducteurs au moyen d'un circuit logique (A1, NA1, I1) connecté en sortie aux seconds moyens conducteurs ($ATL_i$), recevant en entrée le signal de sélection de ligne de mot ($V_{WL}$) et un signal de contrôle (/ERASE), recopiant le signal de sélection de ligne de mot lorsque le signal de contrôle présente une première valeur et délivrant le signal électrique déterminée ($V_{AT}$=0) lorsque le signal présente une seconde valeur.

16. Procédé selon l'une des revendications 11 à 15, dans lequel la programmation d'une cellule mémoire comprend ;

   - l'application de la haute tension (Vpp) sur une ligne de bit ($BL_j$) connectée au transistor d'accès (AT) de la cellule mémoire, et
   - la limitation d'un courant de programmation (Iprog) circulant dans la ligne de bit, le courant de programmation atteint une valeur déterminée (Imax), de manière à empêcher le courant de programmation de dépasser la valeur déterminée (Imax).

17. Procédé Selon la revendication 16, dans lequel la limitation d'un courant de programmation est assurée par un limiteur de courant (TP2) agencé entre la ligne de bit et une source de tension (PMP) fournissant la haute tension (Vpp).

18. Procédé selon l'une des revendications 16 et 17, dans lequel le limiter de cet de programmation (TP2) est agencé dans un verrou de programmation ($LPI_j$) replié à la ligne de bit.

19. Procédé selon l'une des revendications 11 à 18, comprenant l'application, sur la grille du transistor de contrôle de grille ($CGT_k$) d'un mot à programmer, d'une tension (Vcc) inférieure à la haute tension (Vpp).


**Claims**

1. Electrically erasable and programmable memory comprising:

   - at least one word line comprising a plurality of words ($W_{i,k}$), each word comprising a plurality of memory cells ($CE_{i,j}$) and a control gate transistor ($CGT_k$), each memory cell comprising a floating-gate transistor (FGT) and an access transistor (AT), each floating-gate transistor (FGT) comprising a control gate, a first terminal (D) connected to the access transistor and a second terminal (S),
   - a line decoder (RDEC1) supplying at least one word line selection signal ($V_{WL}$), the selection signal ($V_{WL}$) having a high voltage (Vpp) relative to a voltage (Vcc) supplying the memory, at least during the memory cell erasing stages,

- first conducting means (WLSL$_i$) for conveying the selection signal (V$_{WL}$) to the gates of the control gate transistors (CGT$_k$) of the word line,

**characterised in that** it comprises:

- second conducting means (ATL$_i$), which are distinct from the first conducting means, for conveying the selection signal (V$_{WL}$) to the gates of the access transistors (AT) of the word line, and

means (A1, NA1, I1, /ERASE) for preventing the selection signal (V$_{WL}$) from being applied to the second conducting means during the erasure of a word, and applying, instead of the selection signal, a defined electrical signal (V$_{AT}$) having a low or zero potential difference relative to the second terminal of the floating-gate transistors of the word to be erased.

2. Memory according to claim 1, wherein the second terminal of the floating-gate transistors of a word to be erased receives a zero voltage (V$_s$) during the erasure of the word.

3. Memory according to either claim 1 or claim 2, wherein the voltage of the defined electrical signal (V$_{AT}$) is zero during the erasure of the word.

4. Memory according to either claim 1 or claim 2, wherein the defined electrical signal (V$_{AT}$) is brought to a floating potential during the erasure of the word.

5. Memory according to any one of claims 1 to 4, wherein the means for preventing the application of the selection signal comprise a logic circuit (A1, NA1, 11) connected at the output to the second conducting means (ATL$_i$), receiving at the input the selection signal (V$_{WL}$) and a control signal (/ERASE), repeating the selection signal when the control signal has a first value and supplying the defined electrical signal (V$_{AT}$=0) when the control signal has a second value.

6. Memory according to any one of claims 1 to 5, comprising:

- bit lines (BL$_j$) connected to the access transistors (AT), for programming or reading the memory cells,
- means (ICC, LPL$_j$, TP2) for limiting a programming current (Iprog) flowing in at least one bit line during the programming of at least one memory cell, when the programming current reaches a defined value (Imax), so as to prevent the programming current from exceeding the defined value (Imax).

7. Memory according to claim 6, comprising a current limiter (TP2) arranged between each bit line and a voltage source (PMP) providing the high voltage (Vpp).

8. Memory according to claim 7, comprising a current limiter (TP2) arranged in a programming latch (LPL$_j$) connected to at least one bit line.

9. Memory according to either claim 7 or claim 8, wherein the current limiter (TP2) comprises a transistor driven by a reference voltage (Vref) supplied by a current control circuit (ICC) common to all, or some of, the bit lines (BL$_j$) of the memory.

10. Memory according to any one of claims 1 to 9, comprising means for applying a voltage (Vcc), which is lower than the high voltage (Vpp), to the gate of the control gate transistor (CGT$_k$) of a word to be programmed.

11. Method for erasing and programming for use with an electrically erasable and programmable memory comprising:

- at least one word line (WL$_i$) comprising a plurality of words (W$_{i,k}$), each word comprising a plurality of memory cells (CE$_{i,j}$) and a control gate transistor (CGT$_k$), each memory cell comprising an access transistor (AT) and a floating-gate transistor (FGT) having a control gate, a first terminal (D) connected to the access transistor and a second terminal (S), the gates of the floating-gate transistors (FGT) of an individual word (W$_{i,k}$) being controlled by the control gate transistor (CGT$_k$) of the word, such that each word is individually erasable,
- a line decoder (RDEC, RDEC1) supplying at least one word line selection signal (V$_{WL}$), the selection signal (V$_{WL}$) having a high voltage (Vpp) relative to a voltage (Vcc) supplying the memory, at least during the stages of erasing the memory cells of the word line,
- first conducting means (WLSL$_i$) for conveying the selection signal (V$_{WL}$) to the gates of the control gate

transistors ($CGT_k$) of the word line, and
- second conducting means ($ATL_i$), which are distinct from the first conducting means, for conveying the selection signal ($V_{WL}$) to the gates of the access transistors (AT) of the memory cells of the word line,

in which method the erasure of a word from the word line comprises the application of a first electric voltage ($V_{CG}$), equal to the high voltage (Vpp), and a second electric voltage ($V_S=0$) respectively to the gate (G) and to the second terminal (S) of the floating-gate transistors (FGT) of the word to be erased, the first voltage being applied to the floating-gate transistors via the control gate transistor of the word to be erased,
the method being **characterised in that** it comprises the steps of providing, in the memory, means for, during the erasure of a word, preventing a selection signal ($V_{WL}$, Vpp) from being applied to the second conducting means, and applying instead of the selection signal a defined electrical signal ($V_{AT}$) which has a voltage ($V_{AT}=0$) which is different from the first electric voltage (Vpp) and has a low or zero potential difference relative to the second electric voltage ($V_s=0$), such that the access transistors of the word to be erased receive the defined electrical signal ($V_{AT}$).

12. Method according to claim 11, wherein the second voltage ($V_s$) is zero during the erasure of the word.

13. Method according to either claim 11 or claim 12, wherein the voltage of the defined electrical signal ($V_{AT}$) is zero during the erasure of the word.

14. Method according to either claim 11 or claim 12, wherein the defined electrical signal ($V_{AT}$) is brought to a floating potential during the erasure of the word.

15. Method according to any one of claims 11 to 14, wherein the selection signal is prevented from being applied to the second conducting means of a logic circuit (A1, NA1, I1) connected at the output to the second conducting means ($ATL_i$), receiving at the input the word line selection signal ($V_{WL}$) and a control signal (/ERASE), repeating the word line selection signal the when the control signal has a first value and supplying the defined electrical signal ($V_{AT}=0$) when the control signal has a second value.

16. Method according to any one of claims 11 to 15, wherein programming a memory cell comprises:

- applying the high voltage (Vpp) to a bit line ($BL_j$) connected to the access transistor (AT) of the memory cell, and
- limiting a programming current (Iprog) flowing in the bit line, when the programming current reaches a defined value (Imax), so as to prevent the programming current from exceeding the defined value (Imax).

17. Method according to claim 16, wherein the programming current is limited by a current limiter (TP2) arranged between the bit line and a voltage source (PMP) providing the high voltage (Vpp).

18. Method according to either claim 16 or claim 17, wherein the programming current limiter (TP2) is arranged in a programming latch ($LPL_j$) connected to the bit line.

19. Method according to any one of claims 11 to 18, comprising the application of a voltage (Vcc), which is lower than the high voltage (Vpp), to the gate of the control gate transistor ($CGT_k$) of a word to be programmed.

**Patentansprüche**

1. Elektrisch löschbarer und programmierbarer Speicher, aufweisend:

- mindestens eine Wortleitung, die eine Mehrzahl von Wörtern ($W_{i,k}$) aufweist, wobei jedes Wort mehrere Speicherzellen ($CE_{i,j}$) und einen Gate-Steuer-Transistor ($CGT_k$) aufweist, wobei jede Speicherzelle einen Schwebendes-Gate-Transistor (FGT) und einen Zugriffstransistor (AT) aufweist, wobei jeder Schwebendes-Gate-Transistor (FGT) einen Steuer-Gate-Anschluss, einen mit dem Zugriffstransistor verbundenen ersten Anschluss (D) und einen zweiten Anschluss (S) aufweist,
- einen Leitungs-Dekodierer (RDEC1), der mindestens ein Signal ($V_{WL}$) zum Auswählen der Wortleitung ausgibt, wobei das Auswählsignal ($V_{WL}$) relativ zu einer Versorgungsspannung (Vcc) des Speichers zumindest während Phasen des Löschens von Speicherzellen eine hohe Spannung (Vpp) aufweist,
- erste leitende Mittel ($WLSL_i$) zum Zuführen des Auswählsignals ($V_{WL}$) auf die Gate-Anschlüsse der Gate-Steuer-Transistoren ($CGT_k$) der Wortleitung,

**dadurch gekennzeichnet, dass** er aufweist:

- zweite leitende Mittel (ATL$_i$), die sich von den ersten leitenden Mitteln unterscheiden, zum Zuführen des Auswählsignals (V$_{WL}$) auf die Gate-Anschlüsse der Zugriffstransistoren (AT) der Wortleitung, und
- Mittel (A1, NA1, I1, /ERASE) zum Verhindern des Anlegens des Auswählsignals (V$_{WL}$) an die zweiten leitenden Mittel während des Löschens eines Wortes, und zum Anlegen anstelle des Auswählsignals eines bestimmten elektrischen Signals (V$_{AT}$), das im Vergleich zu dem zweiten Anschluss der Schwebendes-Gate-Transistoren des zu löschenden Wortes einen geringen oder keinen Potentialunterschied aufweist.

2. Speicher gemäß Anspruch 1, wobei der zweite Anschluss der Schwebendes-Gate-Transistoren eines zu löschenden Wortes während des Löschens des Wortes eine Nullspannung (V$_S$) empfängt.

3. Speicher gemäß einem der Ansprüche 1 und 2, wobei das bestimmte elektrische Signal (V$_{AT}$) während des Löschens des Wortes einen Nullspannungswert aufweist.

4. Speicher gemäß einem der Ansprüche 1 und 2, wobei das bestimmte elektrische Signal (V$_{AT}$) während des Löschens des Wortes auf ein schwebendes Potential gebracht wird.

5. Speicher gemäß einem der Ansprüche 1 bis 4, wobei die Mittel zum Verhindern des Anlegens des Auswählsignals einen Logikschaltkreis (A1, NA1, I1) aufweisen, der am Ausgang mit den zweiten leitenden Mitteln (ATL$_i$) verbunden ist, am Eingang das Auswählsignal (V$_{WL}$) und ein Steuersignal (/ERASE) empfängt, das Auswählsignal erneut kopiert, wenn das Steuersignal einen ersten Wert aufweist, und das bestimmte elektrische Signal (V$_{AT}$=0) ausgibt, wenn das Steuersignal einen zweiten Wert aufweist.

6. Speicher gemäß einem der Ansprüche 1 bis 5, aufweisend:

- Bitleitungen (BL$_j$), die mit den Zugriffstransistoren (AT) verbunden sind, für das Programmieren oder das Auslesen der Speicherzellen,
- Mittel (ICC, LPI$_j$, TP2) zum Begrenzen eines Programmierstromes (Iprog), der während des Programmierens mindestens einer Speicherzelle in mindestens einer Bitleitung fließt, wenn der Programmierstrom einen bestimmten Wert (Imax) erreicht, so dass verhindert wird, dass der Programmierstrom den bestimmten Wert (Imax) überschreitet.

7. Speicher gemäß Anspruch 6, aufweisend einen Strombegrenzer (TP2), der zwischen jeder Bitleitung und einer die hohe Spannung (Vpp) bereitstellenden Spannungsquelle (PMP) angeordnet ist.

8. Speicher gemäß Anspruch 7, aufweisend einen Strombegrenzer (TP2), der in einem Programmier-Signalspeicher (LPI$_j$) eingerichtet ist, der mit mindestens einer Bitleitung verbunden ist.

9. Speicher gemäß einem der Ansprüche 7 und 8, wobei der Strombegrenzer (TP2) einen Transistor aufweist, der mittels einer Referenzspannung (Vref) gesteuert wird, die von einem Strom-Steuer-Schaltkreis (ICC) ausgegeben wird, der allen oder einem Teil der Bitleitungen (BL$_j$) des Speichers gemeinsam ist.

10. Speicher gemäß einem der Ansprüche 1 bis 9, aufweisend Mittel zum Anlegen einer Spannung (Vcc), die kleiner als die hohe Spannung (Vpp) ist, an den Gate-Anschluss des Gate-Steuer-Transistors (CGT$_k$) eines zu programmierenden Wortes.

11. Verfahren zum Programmieren und Löschen, das auf einen elektrisch löschbaren und programmierbaren Speicher angewendet wird, der aufweist:

- mindestens eine Wortleitung (WLi), die eine Mehrzahl von Wörtern (W$_{i,k}$) aufweist, wobei jedes Wort eine Mehrzahl von Speicherzellen (CE$_{i,j}$) und einen Gate-Steuer-Transistor (CGT$_k$) aufweist, wobei jede Speicherzelle einen Zugriffstransistor (AT) und einen Schwebendes-Gate-Transistor (FGT) aufweist, der einen Steuer-Gate-Anschluss, einen mit dem Zugriffstransistor verbundenen ersten Anschluss (D) und einen zweiten Anschluss (S) aufweist, wobei die Gate-Anschlüsse der Schwebendes-Gate-Transistoren (FGT) eines gleichen Wortes (W$_{i,k}$) von dem Gate-Steuer-Transistor (CGT$_k$) des Wortes gesteuert werden, so dass jedes Wort einzeln löschbar ist,
- einen Leitungs-Dekodierer (RDEC, RDEC1), der mindestens ein Signal (V$_{WL}$) zum Auswählen der Wortleitung ausgibt, wobei das Auswählsignal ($V_{WL}$) zumindest während Phasen des Löschens von Speicherzellen der Wortleitung eine im Vergleich zu einer Versorgungsspannung (Vcc) des Speichers hohe Spannung (Vpp) aufweist,

- erste leitende Mittel ($WLSL_i$) zum Zuführen des Auswählsignals ($V_{WL}$) auf die Gate-Anschlüsse der Gate-Steuer-Transistoren ($CGT_k$) der Wortleitung, und
- zweite leitende Mittel ($ATL_i$), die sich von den ersten leitenden Mitteln unterscheiden, zum Zuführen des Auswählsignals ($V_{WL}$) auf die Gate-Anschlüsse der Zugriffstransistoren (AT) der Speicherzellen der Wortleitung,

wobei bei dem Verfahren das Löschen eines Wortes der Wortleitung das Anlegen einer ersten elektrischen Spannung ($V_{CG}$) gleich der hohen Spannung (Vpp) und einer zweiten elektrischen Spannung ($V_S$=0) jeweils an den Gate-Anschluss (G) und an den zweiten Anschluss (S) der Schwebendes-Gate-Transistoren (FGT) des zu löschenden Wortes aufweist, wobei die erste Spannung mittels des Gate-Steuer-Transistors des zu löschenden Wortes an die Schwebendes-Gate-Transistoren angelegt wird,

wobei das Verfahren **dadurch gekennzeichnet ist, dass** es die aus folgendem bestehenden Schritte aufweist: Vorsehen von Mitteln in dem Speicher zum Verhindern des Anlegens des Auswählsignals ($V_{WL}$, $V_{PP}$) an die zweiten leitenden Mittel während des Löschens eines Wortes, und Anlegen anstelle des Auswählsignals eines bestimmten elektrischen Signals ($V_{AT}$), dessen Spannungswert ($V_{AT}$=0) sich von der ersten elektrischen Spannung (Vpp) unterscheidet und einen geringen oder keinen Potentialunterschied im Vergleich zu der zweiten elektrischen Spannung ($V_S$=0) aufweist, so dass die Zugriffstransistoren des zu löschenden Wortes das bestimmte elektrische Signal ($V_{AT}$) empfangen.

12. Verfahren gemäß Anspruch 11, wobei die zweite Spannung ($V_S$) während des Löschens des Wortes einen Nullwert aufweist.

13. Verfahren gemäß einem der Ansprüche 11 und 12, wobei das bestimmte elektrische Signal ($V_{AT}$) während des Löschens des Wortes einen Nullspannungswert aufweist.

14. Verfahren gemäß einem der Ansprüche 11 und 12, wobei das bestimmte elektrische Signal ($V_{AT}$) während des Löschens des Wortes auf ein schwebendes Potential gebracht wird.

15. Verfahren gemäß einem der Ansprüche 11 bis 14, wobei das Anlegen des Auswählsignals an die zweiten leitenden Mittel mittels eines Logikschaltkreises (A1, NA1, I1), der am Ausgang mit den zweiten leitenden Mitteln ($ATL_i$) verbunden ist, am Eingang das Signal zum Auswählen einer Wortleitung ($V_{WL}$) und ein Steuersignal (/ERASE) empfängt, das Wortleitungs-Auswählsignal erneut kopiert, wenn das Steuersignal einen ersten Wert aufweist, und das bestimmte elektrische Signal ($V_{AT}$=0) ausgibt, wenn das Signal einen zweiten Wert aufweist, verhindert wird.

16. Verfahren gemäß einem der Ansprüche 11 bis 15, wobei das Programmieren einer Speicherzelle aufweist:

- Anlegen der hohen Spannung (Vpp) an eine Bitleitung (BLj), die mit dem Zugriffstransistor (AT) der Speicherzelle verbunden ist, und
- Begrenzen eines Programmierstroms (Iprog), der in der Bitleitung fließt, wenn der Programmierstrom einen bestimmten Wert (Imax) erreicht, so dass verhindert wird, dass der Programmierstrom den bestimmten Wert (Imax) überschreitet.

17. Verfahren gemäß Anspruch 16, wobei das Begrenzen eines Programmierstroms durch einen Strombegrenzer (TP2) gewährleistet wird, der zwischen der Bitleitung und einer Spannungsquelle (PMP) angeordnet ist, die die hohe Spannung (Vpp) bereitstellt.

18. Verfahren gemäß einem der Ansprüche 16 und 17, wobei der Programmierstrombegrenzer (TP2) in einem Programmier-Signalspeicher ($LPI_j$) angeordnet ist, der mit der Bitleitung verbunden ist.

19. Verfahren gemäß einem der Ansprüche 11 bis 18, aufweisend das Anlegen einer Spannung (Vcc), die kleiner als die hohe Spannung (Vpp) ist, an den Gate-Anschluss des Gate-Steuer-Transistors ($CGT_k$) eines zu programmierenden Wortes.

Fig. 1

**Fig. 2**

**Fig. 3A**

**Fig. 3B**

**Fig. 3C**

**Fig. 3D**

**Fig. 3E**

**Fig. 4**

EP 1 278 199 B1

Fig. 5

**Fig. 6**

**Fig. 7**

**Fig. 8**

EP 1 278 199 B1

**Fig. 9**

EP 1 278 199 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0255963 A